# EUROPEAN PATENT APPLICATION

(11) **EP 4 311 109 A1**
(43) Date of publication of application: **24.01.2024**
(21) Application number: 22770415.2
(22) Date of filing: 11.03.2022
(51) Int. Cl.: H03H 9/17

(54) **ACOUSTIC RESONATOR IN THICKNESS DIRECTION EXCITED SHEAR MODE**

(30) Priority: 15.03.2021 CN 202120532330 U; 15.03.2021 CN 202110276005
(71) Applicant: Spectron (Shenzhen) Technologies Co., Ltd, Shenzhen, Guangdong 518033 (CN)
(72) Inventor: GONG, Songbin, Shenzhen, Guangdong 518033 (CN); LV, Ruochen, Shenzhen, Guangdong 518033 (CN)
(74) Representative: Herrero & Asociados, S.L.
(86) International application number: PCT/CN2022/080450
(87) International publication number: WO 2022/194060

(57) **Abstract**

The present application relates to an acoustic resonator in thickness direction excited shear mode, comprising an acoustic mirror, a bottom electrode layer, a piezoelectric layer, an electrode unit, and a transreflector. The acoustic mirror comprises at least one first acoustic reflective layer and at least one second acoustic reflective layer, and the acoustic impedance of each first acoustic reflective layer is less than that of each second acoustic reflective layer. The bottom electrode layer is located on the acoustic mirror. The piezoelectric layer is provided on the bottom electrode layer, and the piezoelectric layer comprises at least one of single crystal lithium niobate or single crystal lithium tantalate. The electrode unit is provided on the piezoelectric layer. The transreflector is provided on the piezoelectric layer and comprises a first reflector located on the first side of the electrode unit and a second reflector located on the second side of the electrode unit, and the transreflector is used for performing transverse reflection on an acoustic wave. The bottom electrode layer and the electrode unit are used for forming an electric field. The present application can have a high electromechanical coupling coefficient and a high Q value at frequencies above 3 GHz.

## Description

### TECHNICAL FIELD

The present application relates to the field of resonator technologies, and, in particular, to an acoustic resonator excited in a thickness shear mode.

### BACKGROUND

Radio frequency acoustic resonators are small structures used for filtering functions or as frequency sources. Acoustic resonators have replaced other types of resonators used in cell phones, small base stations, and Internet of Things (IoT) devices due to their smaller size and higher quality factor (Q). The acoustic resonators enable low loss (low power consumption), high rejection, high signal-to-noise ratio, and thinner packages.

With the release of new communication standards (i.e., fifth-generation mobile networks), it is necessary to extend the operating range of resonators to higher frequencies while maintaining high electromechanical coupling coefficients and high Q values.

### SUMMARY

According to various embodiments of the present application, an acoustic resonator excited in a thickness shear mode is provided, including an acoustic mirror, a bottom electrode layer, a piezoelectric layer, an electrode unit and transverse reflectors. The acoustic mirror includes at least one first acoustic reflective layer and at least one second acoustic reflective layer, and acoustic impedance of each first acoustic reflective layer is less than the acoustic impedance of each second acoustic reflective layer. The bottom electrode layer is arranged on the acoustic mirror. The piezoelectric layer is arranged on the bottom electrode layer, and the piezoelectric layer includes at least one of single crystal lithium niobate or single crystal lithium tantalate. The electrode unit is arranged on the piezoelectric layer. The transverse reflectors are arranged on the piezoelectric layer. The transverse reflectors include a first reflector arranged on a first side of the electrode unit and a second reflector arranged on a second side of the electrode unit, the first side and the second side are opposite sides, and the transverse reflectors are configured to transversely reflect an acoustic wave. The bottom electrode layer and the electrode unit are configured to apply an electric field.

In an embodiment, a direction of the electric field formed by the bottom electrode layer and the electrode unit is substantially the same as a thickness direction of the piezoelectric layer, and the bottom electrode layer and the electrode unit are further configured to generate a shear mode mechanical wave across a thickness of the entire piezoelectric layer.

In an embodiment, a thickness of the first acoustic reflective layer farther away from the bottom electrode layer is larger, and a thickness of the second acoustic reflective layer farther away from the bottom electrode layer is larger.

In an embodiment, the acoustic mirror includes three layers of the first acoustic reflective layer and two layers of the second acoustic reflective layer, and the first acoustic reflective layer and the second acoustic reflective layer in the acoustic mirror are arranged alternatively.

In an embodiment, a material of the first acoustic reflective layer includes at least one of silicon dioxide, aluminum, benzocyclobutene, polyimide or spin on glass, and a material of the second acoustic reflective layer includes at least one of molybdenum, tungsten, titanium, platinum, aluminum nitride, tungsten oxide or silicon nitride.

In an embodiment, the electrode unit includes a first common electrode, a second common electrode, a plurality of first interdigital electrodes and a plurality of second interdigital electrodes. Each of the first interdigital electrodes is electrically connected to the first common electrode, each of the second interdigital electrodes is electrically connected to the second common electrode, and any of the first interdigital electrodes is insulated from any of the second interdigital electrodes. The first common electrode is configured to receive an input voltage, and the second common electrode is configured for grounding.

In an embodiment, the acoustic resonator further includes a passivation layer arranged on the piezoelectric layer. The passivation layer covers each of the first interdigital electrodes and each of the second interdigital electrodes.

In an embodiment, a direction of a connecting line between the transverse reflectors on both sides of the electrode unit is the same as a propagation direction of the acoustic wave. A width of the bottom electrode layer is smaller than a spacing between the first common electrode and the second common electrode, so that an orthographic projection of the bottom electrode layer on a plane where the electrode unit is located is between the first common electrode and the second common electrode. Orthographic projections of each of the first acoustic reflective layers and each of the second acoustic reflective layers on the plane exceed the first reflector and the second reflector in the direction of the connecting line, respectively.

In an embodiment, the first reflector and the second reflector both include at least one electrode strip. A distance between the center of an electrode strip closest to the electrode unit in the first reflector and the center of the interdigital electrode on an edge of the first side of the electrode unit is equal to 1/8 to 2 wavelengths of the acoustic wave, and a distance between the center of the electrode strip closest to the electrode unit in the second reflector and the center of the interdigital electrode on an edge of the second side of the electrode unit is equal to 1/8 to 2 wavelengths of the acoustic wave.

In an embodiment, the acoustic resonator further includes a first metal structure arranged on the first common electrode and a second metal structure arranged on the second common electrode. Thicknesses of the first metal structure and the second metal structure are greater than a thickness of the electrode unit respectively. The first metal structure and the second metal structure are used for acoustic reflection in a second direction, and the second direction is perpendicular to a propagation direction of the acoustic wave.

In an embodiment, an orthographic projection of each of the second acoustic reflective layers on a plane where the bottom electrode layer is located exceeds two sides of the bottom electrode layer in a first direction, or orthographic projections of each of the first acoustic reflective layers and each of the second acoustic reflective layers on the plane where the bottom electrode layer is located are covered by the bottom electrode layer respectively. The first direction is parallel to a propagation direction of the acoustic wave.

In an embodiment, a material of the electrode unit is the same as the material of the transverse reflectors and is at least one of a metal or a metallic alloy.

In an embodiment, one of the at least one first acoustic reflective layer is closer to the bottom electrode layer than all of the second acoustic reflective layers.

In an embodiment, the acoustic resonator further includes a carrier wafer. The acoustic mirror is arranged on the carrier wafer.

In an embodiment, the acoustic resonator further includes a bonding auxiliary layer arranged between the carrier wafer and the acoustic mirror.

One or more embodiments of the present application will be described in detail below with reference to drawings. Other features, objects and advantages of the present application will become more apparent from the description, drawings, and claims.

### BRIEF DESCRIPTION OF THE DRAWINGS

In order to better describe and illustrate embodiments and/or examples of the present application disclosed herein, one or more accompanying drawings may be referred. Additional details or examples used to describe the figures should not be considered limitations on the scope of any of the disclosed application, the presently described embodiments and/or examples, and the presently understood best modes of the application.
FIG. 1 is a top view of a portion of an acoustic resonator excited in a thickness shear mode according to an embodiment.
FIG. 2 is a cross-sectional view taken along the line A-A' in FIG. 1.
FIG. 3 is a schematic diagram showing a propagation direction of an electric field and a propagation direction of a mechanical wave in a piezoelectric layer according to a proposed embodiment.
FIG. 4 is a schematic diagram showing a thickness of each reflective layer of a reflector according to an embodiment.
FIG. 5 is a schematic diagram showing a structure of a first reflector according to an embodiment.
FIG. 6 is a cross-sectional view taken along the line B-B' in FIG. 1.
FIG. 7 is a schematic diagram of Wg according to an embodiment.
FIG. 8 is a simulation result of a characteristic admittance of an acoustic resonator excited in a thickness shear mode according to an embodiment.

### DETAILED DESCRIPTION OF THE EMBODIMENTS

In order to facilitate understanding of the present application, the present application will be described more fully below with reference to the relevant accompanying drawings. Embodiments of the present application are presented in the accompanying drawings. However, the present application may be implemented in many different forms and is not limited to the embodiments described herein. Rather, these embodiments are provided for the purpose of making the present application more thorough and comprehensive.

Unless otherwise defined, all technical and scientific terms used herein have the same meaning as commonly understood by those skilled in the technical field to which the present application belongs. The terms used herein in the specification of the application are for the purpose of describing specific embodiments only, and are not intended to limit the application.

It should be understood that when an element or layer is referred to as being "on", "adjacent", "connected to", or "coupled to" other elements or layers, it may be directly on, adjacent to, connected to, or coupled to other elements or layers, or there may be intervening elements or layers. Conversely, when the element is referred to as "directly on", "directly adjacent to", "directly connected", or "directly coupled to" other elements or layers, there is no intervening elements or layers. It should be understood that although the terms first, second, third, etc. may be used to describe various elements, components, regions, layers, doping types and/or portions, these elements, components, regions, layers, doping types and/or portions should not be limited by these terms. These terms are used only to distinguish one element, component, region, layer, doping type or portion from another element, component, region, layer, doping type or portion. Accordingly, without departing from the teachings of this application, the first element, component, region, layer, doping type or portion discussed below may be represented as a second element, component, region, layer or portion. For example, the first doping type may be referred to as the second doping type, and similarly, the second doping type may be referred to as the first doping type. The first doping type and the second doping type are different doping types, for example, the first doping type may be P-type and the second doping type may be N-type, or the first doping type may be N-type and the second doping type may be P-type.

Spatial relational terms such as "beneath", "below", "underneath", "under", "on", "above", etc., may be used herein to describe the relationship of one element or feature to other elements or features shown in the figures. It should be understood that, in addition to the orientation depicted in the figures, the spatial relational terms further include different orientations of a device in use and operation. For example, if the device in the figures is turned over, elements or features described as "below" or "under" or "beneath" other elements or features would be oriented "above" the other elements or features. Thus, the exemplary terms "below" and "beneath" may include both above and below orientations. In addition, the device may also include additional orientations (e.g., rotation of 90 degrees or other orientations), and the spatial descriptors used herein interpreted accordingly.

As used herein, the singular forms "a", "an" and "the" may also include the plural forms, unless the context clearly indicates otherwise. It should also be understood that the terms "includes/comprises" or "has" etc. designate the presence of stated features, integers, steps, operations, components, parts or combinations thereof, but do not preclude the possibility of the presence or addition of one or more other features, integers, steps, operations, components, parts or combinations thereof. Meanwhile, the term "and/or" as used herein includes any and all combinations of the relevant listed items in the present specification.

Embodiments of the application are described herein with reference to cross-sectional views of schematic diagrams of ideal embodiments (and intermediate structures) of the present application, so that variations in the shape shown due to, for example, manufacturing techniques and/or tolerances, can be expected. Accordingly, embodiments of the present application should not be limited to the particular shapes of regions illustrated herein but are to include deviations in shapes that result, for example, from manufacturing techniques. For example, an implanted region illustrated as a rectangle generally has rounded or curved features and/or a gradient of implant concentration at its edges, rather than a binary change from the implanted region to a non-implanted region. Likewise, a buried region formed by implantation may result in some implantation in a region between the buried region and a surface through which the implantation was performed. Accordingly, the regions shown in the figures are substantially schematic and their shapes do not indicate the actual shape of the region of the device and do not limit the scope of the present application.

Bulk acoustic wave (BAW) and surface acoustic wave (SAW) resonators are the most commonly used devices for synthesizing filters and resonators between 0.6GHz and 3GHz. These acoustic devices are commercially successful and are widely used in mobile phone front-end modules or as discrete components in radio front-ends. Existing bulk acoustic wave and surface acoustic wave devices can achieve a Q value of more than 1000 and an electromechanical coupling coefficient of about 7%-10% at frequencies below 3 GHz. However, extending its frequency range above 3GHz will encounter some technical uncertainties and physical limits. The new 5G standard requires the electromechanical coupling coefficient to be more than 10%, which cannot be achieved by the bulk acoustic wave and surface acoustic wave devices without changing the material or working mode of the bulk acoustic wave and surface acoustic wave devices. Likewise, material loss poses a fundamental limit to the maximum Q value achieved by conventional bulk acoustic wave and surface acoustic wave devices above 3 GHz.

In summary, the market needs new devices with a high electromechanical coupling and a high quality factor at frequencies above 3 GHz.

The present application aims to provide a novel wafer-level mechanical/acoustic resonator capable of having a high Q value and a high electromechanical coupling coefficient at a frequency above 3 GHz. The resonator supports the synthesis of high-performance passband filters to meet the new requirements of 5G communication standards and future upgrades.

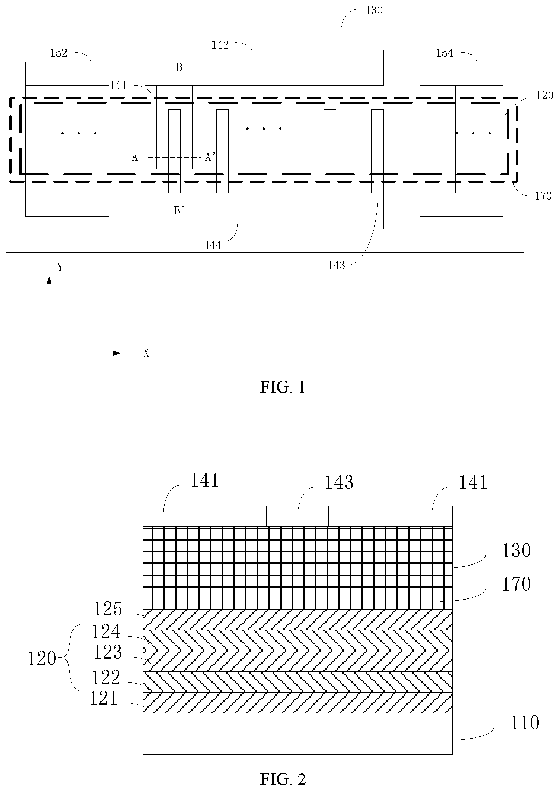

FIG. 1 is a top view showing a portion of an acoustic resonator excited in a thickness shear mode according to an embodiment, and FIG. 2 is a cross-sectional view taken along the line A-A' in FIG. 1. Referring to FIGS. 1 and 2, the acoustic resonator excited in a thickness shear mode includes an acoustic mirror 120, a bottom electrode layer 170, a piezoelectric layer 130, an electrode unit and transverse reflectors. FIG. 1 is primarily intended to illustrate the shapes of the electrode unit and the transverse reflectors in corresponding embodiments, thereby omitting other structures on the piezoelectric layer 130.

The electrode unit is arranged on the piezoelectric layer 130. The electrode unit may include interdigital electrodes. In the embodiments shown in FIGS. 1 and 2, the electrode unit includes a group of first interdigital electrodes 141 and a group of second interdigital electrodes 143. The first interdigital electrodes 141 and the second interdigital electrodes 143 extend in the Y direction in FIG. 1, so they are parallel to each other. Each first interdigital electrode 141 is insulated from each second interdigital electrode 143. The first interdigital electrode 141 is configured to receive an input voltage, and the second interdigital electrode 143 is configured for grounding. The electrode unit further includes a first common electrode 142 and a second common electrode 144. One end of each first interdigital electrode 141 is connected to the first common electrode 142, and one end of each second interdigital electrode 143 is connected to the second common electrode 144. The common electrode is also called a bus bar.

The transverse reflectors are also arranged on the piezoelectric layer 130, and can be arranged on the same layer as the electrode unit. The transverse reflectors include a first reflector 152 arranged on a first side (left side in FIG. 1) of the electrode unit and a second reflector 154 arranged on a second side (right side in FIG. 1) of the electrode unit. The transverse reflectors are insulated from the electrode unit and configured to transversely reflect an acoustic wave.

The piezoelectric layer 130 is arranged on the bottom electrode layer 170. The piezoelectric layer 130 includes at least one of single crystal lithium niobate or single crystal lithium tantalate.

The bottom electrode layer 170 is arranged on the acoustic mirror 120. The bottom electrode layer 170 and the electrode unit are configured to apply an electric field.

The acoustic mirror 120 includes at least one first acoustic reflective layer and at least one second acoustic reflective layer, and acoustic impedance of each first acoustic reflective layer is less than the acoustic impedance of each second acoustic reflective layer. In an embodiment of the present application, the layer closest to the bottom electrode layer 170 in the acoustic mirror 120 should be the first acoustic reflective layer, i.e., there is one first acoustic reflective layer closer to the bottom electrode than all the second acoustic reflective layers 170. In the embodiment shown in FIG. 2, the acoustic mirror 120 includes three layers of first acoustic reflective layers (i.e., the first acoustic reflective layer 121, the first acoustic reflective layer 123, and the first acoustic reflective layer 125) and two layers of second acoustic reflective layers (i.e., the second acoustic reflective layer 122 and the second acoustic reflective layer 124), and each first acoustic reflective layer and each second acoustic reflective layer are arranged alternatively.

The above-mentioned acoustic resonator excited in a thickness shear mode generates the electric field by the electrode unit and the bottom electrode layer, and the transverse reflectors transversely reflect the acoustic wave, so that the acoustic resonator can be excited in a shear vibration mode in the thickness direction. And because the piezoelectric layer is made of the single crystal lithium niobate or lithium tantalate, the acoustic resonator has a high electromechanical coupling coefficient and a high Q value at a frequency above 3 GHz.

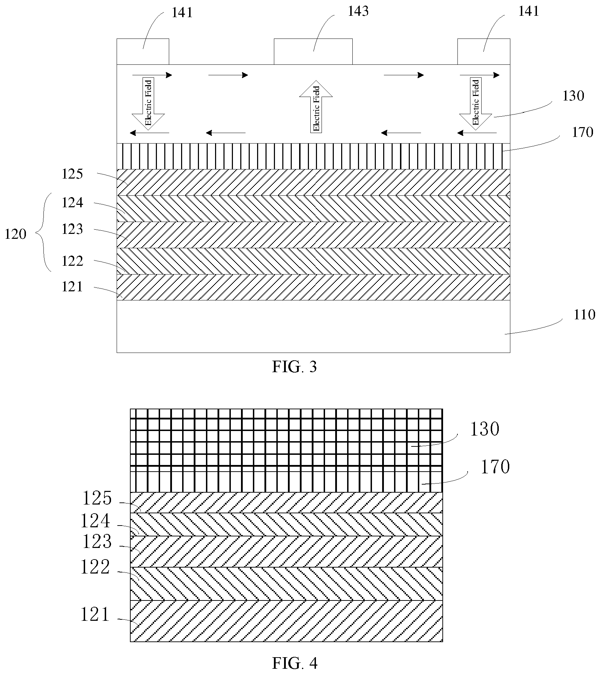

Referring to FIG. 3, the big arrow in the figure represents a direction of the electric field, the small arrow represents a propagation direction of a mechanical wave of the shear vibration mode, and the direction of the electric field is substantially the same as a thickness direction of the piezoelectric layer 130. The bottom electrode layer 170 and the electrode unit are further configured to generate a shear mode mechanical wave across a thickness of the entire piezoelectric layer 130. The single crystal lithium niobate or lithium tantalate in combination with the electrode unit structure and the transverse reflector structure of the present application can obtain an optimized shear vibration mode. The optimized shear vibration mode has a greater acoustic wave velocity, and can reach higher frequencies than traditional commercial filters while the key dimensions (such as a spacing between fingers) of the device remain unchanged.

In an embodiment of the present application, a material of the electrode unit is the same as the material of the transverse reflector and is at least one of a metal or a metallic alloy. In an embodiment of the present application, the electrode unit can be made of aluminum (Al), copper (Cu), aluminum copper (AlCu), aluminum silicon copper (AlSiCu), molybdenum (Mo), tungsten (W), silver (Ag) or made of any other conductive metal.

In an embodiment of the present application, the material of the bottom electrode layer 170 may include one or more of molybdenum, tungsten, ruthenium, platinum, titanium, aluminum, aluminum copper, aluminum silicon copper, and chromium.

In the embodiment shown in FIG. 2, the acoustic resonator excited in a thickness shear mode further includes a carrier wafer 110. The acoustic mirror 120 is arranged on the carrier wafer 110.

In an embodiment of the present application, the acoustic resonator further includes a bonding auxiliary layer arranged between the carrier wafer 110 and the acoustic mirror 120. In an embodiment of the present application, the bonding auxiliary layer is a thin layer of silicon dioxide.

In an embodiment of the present application, each first acoustic reflective layer is made of low acoustic impedance material, and each second acoustic reflective layer is made of high acoustic impedance material. The low acoustic impedance material may be at least one of silicon dioxide, aluminum, benzocyclobutene (BCB), polyimide or spin on glass, and the high acoustic impedance material may be at least one of molybdenum, tungsten, titanium, platinum, aluminum nitride, tungsten oxide or silicon nitride. It can be understood that in other embodiments, the low acoustic impedance material and the high acoustic impedance material can also use combinations of other materials with a larger impedance ratio.

Each of the first and second acoustic reflective layers of the acoustic mirror 120 may have equal or unequal thicknesses. In an embodiment of the present application, the thickness of the first acoustic reflective layer farther away from the bottom electrode layer 170 is larger, and the thickness of the second acoustic reflective layer farther away from the bottom electrode layer 170 is larger. This design can obtain a larger Q value. Referring to FIG.4, in the embodiment shown in FIG.4, the thickness Tl1 of the first acoustic reflective layer 121 is less than the thickness Tl2 of the first acoustic reflective layer 123 which is less than the thickness Tl3 of the first acoustic reflective layer 125, and the thickness Th1 of the second acoustic reflective layer 122 is less than the thickness Th2 of the second acoustic reflective layer 124. It can be understood that in other embodiments, the thickness relationship between each first acoustic reflective layer and the second acoustic reflective layer can also be set according to other rules, such as Tl1=Tl2=Tl3 and Th1=Th2, or Tl1>Tl2>Tl3 and Th1>Th2, or Tl1<Tl2, Tl3<Tl2, and Th1<Th2.

FIG. 1 also shows the position of the acoustic mirror 120 from the top view. The X direction in FIG. 1 is a propagation direction of the acoustic wave. The bottom electrode layer 170 is formed by patterning, and its width in the Y direction may be the same as or different from (may be larger or smaller) a width of the acoustic mirror 120 in the Y direction. The width (i.e., the dimension in the Y direction in FIG. 1) of the bottom electrode layer 170 is smaller than a spacing between the first common electrode 142 and the second common electrode 144, so that an orthographic projection of the bottom electrode layer 170 on a plane where the electrode unit is located is between the first common electrode 142 and the second common electrode 144 in the Y direction. In the embodiment shown in FIG. 1, a side of the bottom electrode layer 170 close to the first common electrode 142 in the orthographic projection exceeds an end of each second interdigital electrode 143 close to the first common electrode 142, and a side of the bottom electrode layer 170 close to the second common electrode 144 exceeds an end of each first interdigital electrode 141 close to the second common electrode 144, i.e., the bottom electrode layer 170 is wide enough so that the two sides of its orthographic projection fall outside the second interdigital electrode 143 or the first interdigital electrode 141 respectively.

In the embodiment shown in FIG. 1, the length and width of the bottom electrode layer 170 are larger than those of the acoustic mirror 120, thereby covering the acoustic mirror 120 in both the X direction and the Y direction.

The dimensions in the X direction of the first acoustic reflective layer and the second acoustic reflective layer may be the same or different. In the embodiment shown in FIG. 1, orthographic projections of each first acoustic reflective layer and each second acoustic reflective layer on a plane where the electrode unit is located exceed the first reflector 152 and the second reflector 154 in the X direction respectively, i.e., the left edge of the orthographic projection falls to the left of the left edge of the first reflector 152, and the right edge falls to the right of the right edge of the second reflector 154.

In the embodiment shown in FIG. 1, orthographic projections of each first acoustic reflective layer and each second acoustic reflective layer on a plane where the bottom electrode layer 170 is located are covered by the bottom electrode layer 170 in the X direction respectively (i.e., the lengths of the first acoustic reflective layer and the second acoustic reflective layer in the X direction are smaller than the length of the bottom electrode layer 170 in the X direction). In another embodiment of the present application, an orthographic projection of each second acoustic reflective layer on the plane where the bottom electrode layer 170 is located exceeds the two sides of the bottom electrode layer 170 in the X direction, i.e., the length of the second acoustic reflective layer in the X direction is greater than the length of the bottom electrode layer 170 in the X direction.

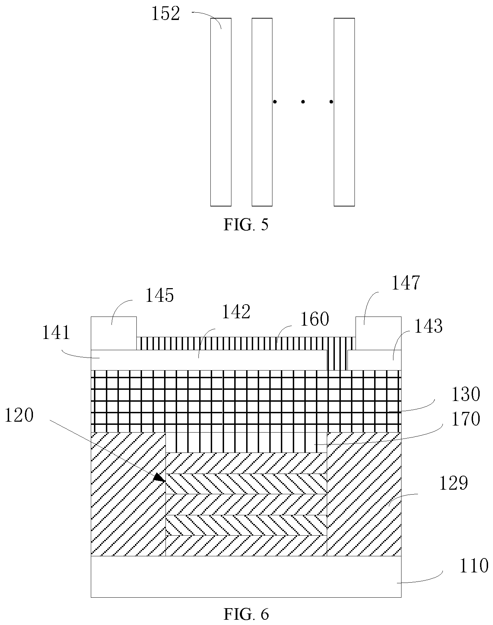

As shown in FIG. 5, electrode strips of the transverse reflectors can be disconnected from one another, or can be connected to one another by a transverse structure as shown in FIG. 1. The electrode strips of the transverse reflectors can be arranged parallel to the fingers of the electrode unit.

FIG. 6 is a cross-sectional view taken along the line B-B' in FIG. 1. In this embodiment, the areas of the acoustic mirror 120 and the bottom electrode layer 170 are smaller than the areas of the piezoelectric layer 130 and the carrier wafer 110, so a filling layer is provided around the acoustic mirror 120 and the bottom electrode layer 170. In an embodiment of the present application, a material of the filling layer may include one or more of silicon dioxide, molybdenum, tungsten, tungsten oxide or silicon nitride. In an embodiment of the present application, the material of the filling layer is the same as the material of each first acoustic reflective layer, so as to improve a quality factor of the acoustic resonator.

In the embodiment shown in FIG. 6, the acoustic resonator excited in a thickness shear mode further includes a first metal structure 145 arranged on the first common electrode 141 and a second metal structure 147 arranged on the second common electrode 143. The thicknesses of the first metal structure 145 and the second metal structure 147 are greater than a thickness of the electrode unit, respectively. The first metal structure 145 and the second metal structure 147 are used for acoustic reflection in the Y direction of FIG. 1.

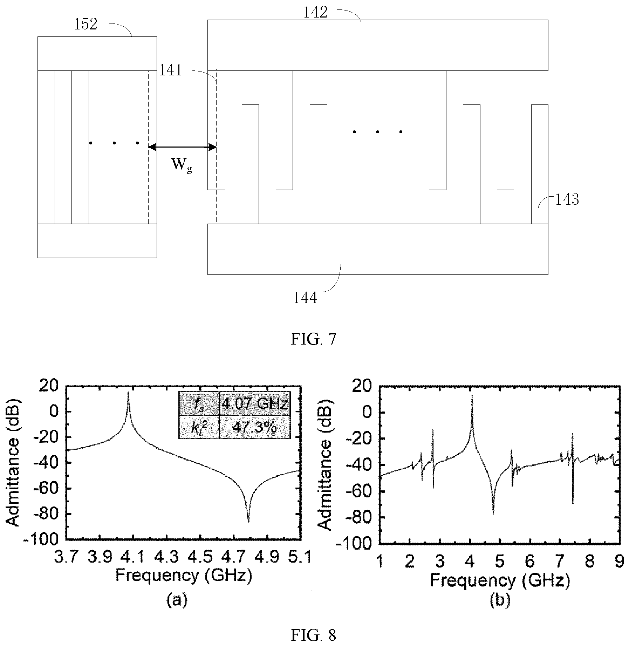

In an embodiment of the present application, a distance Wg (referring to FIG. 7) between the center of an electrode strip closest to the electrode unit in the first reflector 152 and the center of the interdigital electrode on an edge of the first side of the electrode unit is equal to 1/8 to 2 wavelengths of the acoustic wave. A distance between the center of the electrode strip closest to the electrode unit in the second reflector 154 and the center of the interdigital electrode on an edge of the second side of the electrode unit is equal to 1/8 to 2 wavelengths of the acoustic wave.

A vibration frequency of the mechanical wave in the shear vibration mode formed in the piezoelectric layer 130 is related to the thickness of each film layer and the spacing between adjacent interdigital electrodes in the electrode unit. A stress is mainly confined to a metal-free area between the first interdigital electrode 141 and the second interdigital electrode 143.

In the embodiment shown in FIG. 6, the acoustic resonator excited in a thickness shear mode further includes a passivation layer 160. The passivation layer 160 is arranged on the piezoelectric layer 130, and covers the first interdigital electrode 141 and the second interdigital electrode 143. The passivation layer 160 can reduce a frequency temperature coefficient of the resonator and passivate the metal electrodes.

FIG. 8 is a simulation result of a characteristic admittance of the acoustic resonator excited in a thickness shear mode according to an embodiment. The curve in the diagram (b) is a part of the curve of in the diagram (a), and kt is the electromechanical coupling coefficient. The characteristic frequency simulation is used to obtain an optimized thickness of the stacked reflector with a resonant frequency of 4.07 GHz. The same characteristic frequency analysis is used to determine a best reflective layer position in the plane and a relative position of the reflective layer stack with respect to the interdigital electrode.

In the description of this specification, reference to the description of the terms "some embodiments", "other embodiments", "ideal embodiments", etc. means that a particular feature, structure, material or feature described in connection with the embodiment or example is included in the present specification at least one embodiment or example of the application. In this specification, schematic descriptions of the above terms do not necessarily refer to the same embodiment or example.

The technical features in the above embodiments can be combined arbitrarily. For concise description, not all possible combinations of the technical features in the above embodiments are described. However, all the combinations of the technical features are to be considered as falling within the scope described in this specification provided that they do not conflict with each other.

The above-mentioned embodiments only describe several implementations of the present application, and their description is specific and detailed, but should not be understood as a limitation on the patent scope of the present application. It should be pointed out that for those skilled in the art may further make variations and improvements without departing from the conception of the present application, and these all fall within the protection scope of the present application. Therefore, the protection scope of the present application should be subject to the appended claims.

## Claims

1. An acoustic resonator excited in a thickness shear mode, **characterized by** comprising:
an acoustic mirror comprising at least one first acoustic reflective layer and at least one second acoustic reflective layer, acoustic impedance of each first acoustic reflective layer being less than the acoustic impedance of each second acoustic reflective layer;
a bottom electrode layer arranged on the acoustic mirror;
a piezoelectric layer arranged on the bottom electrode layer, the piezoelectric layer comprising at least one of single crystal lithium niobate or single crystal lithium tantalate;
an electrode unit arranged on the piezoelectric layer; and
transverse reflectors arranged on the piezoelectric layer, the transverse reflectors comprising a first reflector arranged on a first side of the electrode unit and a second reflector arranged on a second side of the electrode unit, the first side and the second side being opposite sides, and the transverse reflectors being configured to transversely reflect an acoustic wave;
wherein the bottom electrode layer and the electrode unit are configured to apply an electric field.

2. The acoustic resonator excited in a thickness shear mode according to claim 1, **characterized in that** a direction of the electric field formed by the bottom electrode layer and the electrode unit is substantially the same as a thickness direction of the piezoelectric layer, and the bottom electrode layer and the electrode unit are further configured to generate a shear mode mechanical wave across a thickness of the entire piezoelectric layer.

3. The acoustic resonator excited in a thickness shear mode according to claim 1, **characterized in that** a thickness of the first acoustic reflective layer farther away from the bottom electrode layer is larger, and a thickness of the second acoustic reflective layer farther away from the bottom electrode layer is larger.

4. The acoustic resonator excited in a thickness shear mode according to claim 1, **characterized in that** the acoustic mirror comprises three layers of the first acoustic reflective layer and two layers of the second acoustic reflective layer, and the first acoustic reflective layer and the second acoustic reflective layer in the acoustic mirror are arranged alternatively.

5. The acoustic resonator excited in a thickness shear mode according to claim 1, **characterized in that** a material of the first acoustic reflective layer comprises at least one of silicon dioxide, aluminum, benzocyclobutene, polyimide or spin on glass, and a material of the second acoustic reflective layer comprises at least one of molybdenum, tungsten, titanium, platinum, aluminum nitride, tungsten oxide or silicon nitride.

6. The acoustic resonator excited in a thickness shear mode according to claim 1, **characterized in that** the electrode unit comprises a first common electrode, a second common electrode, a plurality of first interdigital electrodes and a plurality of second interdigital electrodes, each of the first interdigital electrodes is electrically connected to the first common electrode, each of the second interdigital electrodes is electrically connected to the second common electrode, any of the first interdigital electrodes is insulated from any of the second interdigital electrodes, the first common electrode is configured to receive an input voltage, and the second common electrode is configured for grounding.

7. The acoustic resonator excited in a thickness shear mode according to claim 6, **characterized by** further comprising a passivation layer arranged on the piezoelectric layer, the passivation layer covering each of the first interdigital electrodes and each of the second interdigital electrodes.

8. The acoustic resonator excited in a thickness shear mode according to claim 6, **characterized in that** a direction of a connecting line between the transverse reflectors on both sides of the electrode unit is the same as a propagation direction of the acoustic wave, a width of the bottom electrode layer is smaller than a spacing between the first common electrode and the second common electrode, so that an orthographic projection of the bottom electrode layer on a plane where the electrode unit is located is between the first common electrode and the second common electrode, and orthographic projections of each of the first acoustic reflective layers and each of the second acoustic reflective layers on the plane exceed the first reflector and the second reflector in the direction of the connecting line, respectively.

9. The acoustic resonator excited in a thickness shear mode according to claim 6, **characterized in that** the first reflector and the second reflector both comprise at least one electrode strip, a distance between the center of an electrode strip closest to the electrode unit in the first reflector and the center of the interdigital electrode on an edge of the first side of the electrode unit is equal to 1/8 to 2 wavelengths of the acoustic wave, and a distance between the center of the electrode strip closest to the electrode unit in the second reflector and the center of the interdigital electrode on an edge of the second side of the electrode unit is equal to 1/8 to 2 wavelengths of the acoustic wave.

10. The acoustic resonator excited in a thickness shear mode according to claim 6, **characterized by** further comprising a first metal structure arranged on the first common electrode and a second metal structure arranged on the second common electrode, wherein thicknesses of the first metal structure and the second metal structure are greater than a thickness of the electrode unit respectively, the first metal structure and the second metal structure are used for acoustic reflection in a second direction, and the second direction is perpendicular to a propagation direction of the acoustic wave.

11. The acoustic resonator excited in a thickness shear mode according to claim 1, **characterized in that** an orthographic projection of each of the second acoustic reflective layers on a plane where the bottom electrode layer is located exceeds two sides of the bottom electrode layer in a first direction, or orthographic projections of each of the first acoustic reflective layers and each of the second acoustic reflective layers on the plane where the bottom electrode layer is located are covered by the bottom electrode layer respectively;
wherein the first direction is parallel to a propagation direction of the acoustic wave.

12. The acoustic resonator excited in a thickness shear mode according to claim 1, **characterized in that** a material of the electrode unit is the same as the material of the transverse reflectors and is at least one of a metal or a metallic alloy.

13. The acoustic resonator excited in a thickness shear mode according to claim 1, **characterized in that** one of the at least one first acoustic reflective layer is closer to the bottom electrode layer than all of the second acoustic reflective layers.

14. The acoustic resonator excited in a thickness shear mode according to claim 1, **characterized by** further comprising a carrier wafer, wherein the acoustic mirror is arranged on the carrier wafer.

15. The acoustic resonator excited in a thickness shear mode according to claim 14, **characterized by** further comprising a bonding auxiliary layer arranged between the carrier wafer and the acoustic mirror.
